# EUROPEAN PATENT SPECIFICATION

(11) **EP 3 412 795 B1**
(45) Date of publication and mention of the grant of the patent: **29.09.2021**
(21) Application number: 17747162.0
(22) Date of filing: 12.01.2017
(51) Int. Cl.: C23C 14/34, B22F 3/10, B22F 5/10, C22C 1/04, C22C 9/00

(54) **METHOD OF MANUFACTURING CU-GA ALLOY SPUTTERING TARGET**
VERFAHREN ZUR HERSTELLUNG EINES SPUTTERTARGETS AUS CU-GA-LEGIERUNG
MÉTHODE DE FABRICATION D'UNE CIBLE DE PULVÉRISATION EN ALLIAGE CU-GA

(30) Priority: 03.02.2016 JP 2016019282; 26.12.2016 JP 2016250827
(43) Date of publication of application: 12.12.2018
(73) Proprietor: Mitsubishi Materials Corporation, Chiyoda-ku Tokyo 100-8117 (JP)
(72) Inventor: YOSHIDA Yuki, Naka-shi Ibaraki 311-0102 (JP); UEDA Toshiaki, Naka-shi Ibaraki 311-0102 (JP); MORI Satoru, Naka-shi Ibaraki 311-0102 (JP)
(74) Representative: Hoffmann Eitle
(86) International application number: PCT/JP2017/000768
(87) International publication number: WO 2017/134999

(56) References cited:
- JP-A- 2008 138 232
- JP-A- 2014 141 722
- JP-A- 2015 030 870
- JP-A- 2015 105 414
- JP-A- 2015 105 414
- JP-A- 2015 175 035
- JP-A- 2016 125 113

## Description

### Technical Field

The present invention relates to a method of manufacturing a Cu-Ga alloy sputtering target that includes a hollow portion having, for example, a cylindrical shape and a Cu-Ga alloy sputtering target.

### Background Art

In the related art, as a thin film solar cell formed of a compound semiconductor, a CIGS solar cell that includes a light-absorbing layer formed of a Cu-In-Ga-Se quaternary alloy thin film is provided.

Here, as a method of forming the light-absorbing layer formed of a Cu-In-Ga-Se quaternary alloy thin film, a method of forming the light-absorbing layer using a vapor deposition method is known. A solar cell that includes a light-absorbing layer formed using a vapor deposition method has an advantageous effect in that the energy conversion efficiency is high, but has a problem in that it is not suitable for an increase in area and the production efficiency is low.

Therefore, as a method of forming the light-absorbing layer formed of a Cu-In-Ga-Se quaternary alloy thin film, a method of forming a multilayer film of an In film and a Cu-Ga film and performing a heat treatment on the multilayer film in a Se atmosphere to selenize the multilayer film is provided. Here, in order to form the In film and the Cu-Ga film, a sputtering method in which an In sputtering target and a Cu-Ga alloy sputtering target are used is applied.

As the Cu-Ga alloy sputtering target, a flat sputtering target and a cylindrical sputtering target are proposed. Here, an outer peripheral surface of the cylindrical sputtering target is a sputtering surface, and sputtering is performed while rotating the cylindrical sputtering target. Therefore, the cylindrical sputtering target is more suitable for continuous film formation as compared to a case where the flat sputtering target is used, and has an advantageous effect in that the efficiency in use of the sputtering target is excellent.

Here, the Cu-Ga alloy sputtering target is manufactured, for example, using methods described in PTLs 1 to 4.
PTL 1 discloses a method of performing a heat treatment on Cu-Ga alloy powder in a vacuum or an inert gas atmosphere at a temperature of 400°C or more and 900°C or less and then sintering the Cu-Ga alloy powder through pressing.
PTL 2 discloses a method of manufacturing a Cu-Ga alloy sputtering target having a predetermined shape by performing wire-electrical discharge machining on a Cu-Ga alloy ingot obtained by melt casting.
PTL 3 discloses a method of forming a green compact of mixed powder of Cu powder and Cu-Ga alloy powder and pressureless sintering the formed green compact.
PTL 4 discloses a method of charging Cu-Ga alloy powder into a cylindrical capsule and obtaining a Cu-Ga alloy sintered material by hot isostatic pressing (HIP).
PTL 5 relates to a method for manufacturing a cylindrical target by charging a base powder into a ring-shaped space defined by a sleeve and a core bar, pressing the base powder between the sleeve and the core bar with a press member, and sintering the base powder being pressed.

### Citation List

### Patent Literature

[PTL 1] Japanese Unexamined Patent Application, First Publication No. 2012-072466
[PTL 2] Japanese Unexamined Patent Application, First Publication No. 2011-089198
[PTL 3] Japanese Unexamined Patent Application, First Publication No. 2014-019934
[PTL 4] Japanese Unexamined Patent Application, First Publication No. 2014-141722
[PTL 5] JP 2015 105414 A

### Summary of Invention

### Technical Problem

However, in a case where a Cu-Ga alloy sputtering target that includes a hollow portion having a cylindrical shape or the like is manufactured using the pressure sintering method disclosed in PTL 1, a mold in which a core is disposed in a portion corresponding to the hollow portion is used. However, it is difficult to remove the core due to shrinkage of a sintered material during cooling after sintering, and the sintered material may be damaged during the removal of the core.

In addition, in a case where a Cu-Ga alloy ingot is formed in a cylindrical shape using the wire-electrical discharge machining method disclosed in PTL 2, there are problems in that the treatment time is long and the raw material yield also decreases.

In a case where a green compact is formed as described in PTL 3, for example, raw material powder is charged into a rubber mold including a core for a CIP treatment. In this case, unevenness derived from the rubber mold is generated on a side surface of the green compact, and then the unevenness remains during sintering. Therefore, the surface treatment amount of the obtained sintered material increases, and there is a problem in that the raw material yield decreases. In addition, a pressing facility is required, and there is a problem in that the manufacturing costs increase.

In addition, in a case where a cylindrical Cu-Ga alloy sintered material is manufactured by hot isostatic pressing (HIP) as described in PTL 4, a hot pressing facility is required, and thus there is a problem in that the manufacturing costs increase. Further, in PTL 4, in order to remove the capsule attached to the Cu-Ga alloy sintered material, it is necessary to perform lathe machining.

In addition, in a case where a Cu-Ga alloy sputtering target that includes a hollow portion having a cylindrical shape or the like is manufactured using the methods disclosed in PTLs 1, 3, and 4, there is a difference in the progress of sintering between an inside of the cylinder and an outside of the cylinder, and there is a problem such as a difference in characteristics therebetween.

The present invention has been made in consideration of the above-described circumstances, and an object thereof is to provide: a method of manufacturing a Cu-Ga alloy sputtering target in which a Cu-Ga alloy sputtering target including a hollow portion can be manufactured with a high production efficiency at low costs.

### Solution to Problem

The problem is solved by a method according to claim 1.

In the method of manufacturing a Cu-Ga alloy sputtering target according to the present invention having the above-described configuration, a sputtering target is manufactured through the following steps including: a calcining step of forming a calcined material by charging a raw material powder that includes at least a Cu-Ga alloy powder into a mold that includes a core and heating the raw material powder in a reducing atmosphere; and a main sintering step of forming a sintered material by removing the core from the calcined material and heating the calcined material in a reducing atmosphere. Therefore, it is not necessary to use a pressing device or the like, the manufacturing costs can be reduced, and the production efficiency can be improved.

In addition, the main sintering step is provided after the calcining step. Therefore, in the calcining step, the raw material powder may be sintered to have a strength with which the shape can be maintained, and thus the calcining step can end before the occurrence of large sintering shrinkage.

Further, a pressing device is not used. Therefore, the number of pores in the calcined material is small, the reducing gas can be caused to sufficiently flow to the inside of the cylinder and the outside of the cylinder in the main sintering step, and a difference in the progress of sintering between the inside of the cylinder and the outside of the cylinder can be suppressed.

In addition, the method of manufacturing a Cu-Ga alloy sputtering target according to the present invention includes a calcining step of forming a calcined material by charging the raw material powder into a mold that includes a core and heating the raw material powder in a reducing atmosphere, in which the core used in the calcining step is made of a material having a higher linear thermal expansion coefficient than a Cu-Ga alloy constituting the Cu-Ga alloy sputtering target. Therefore, during cooling after the calcining step, the core significantly shrinks, and the core can be easily removed from the calcined material. Accordingly, damages of the calcined material can be suppressed.

The thermal expansion coefficient varies depending on the Ga content. Therefore, a specimen formed of a Cu-Ga alloy having the same composition as a Cu-Ga alloy sputtering target to be manufactured may be prepared and the linear thermal expansion coefficient may be measured in advance such that the material of the core can be selected based on the measured value.

In addition, in the calcining step, the raw material powder is held at a temperature of 100°C or more and 600°C or less for 10 minutes or more and 10 hours or less. Therefore, the strength of the calcined material is secured, and damages of the calcined material during handling such as the subsequent main sintering step can be suppressed.

In the method of manufacturing a Cu-Ga alloy sputtering target according to the present invention, the raw material powder may include a Cu powder and the Cu-Ga alloy powder, and a content of the Cu powder may be 5 mass% or more.

In this case, the content of the Cu powder in the raw material powder is 5 mass% or more. Therefore, in the calcining step, under a low-temperature condition of less than 500°C, the Cu powder is preferentially reduced and necked such that the calcined material having a sufficient strength can be obtained. That is, in a case where only the Cu-Ga alloy powder is used as the raw material powder, it is preferable that the heating temperature in the calcining step is 500°C or more. By the raw material powder including the Cu powder, the heating temperature in the calcining step can be made to be a low-temperature of less than 500°C.

In addition, in the method of manufacturing a Cu-Ga alloy sputtering target according to the present invention, the raw material powder may include a first Cu-Ga alloy powder having a Ga concentration in a range of more than 0 at% and 20 at% or less and a second Cu-Ga alloy powder having a Ga concentration in a range of more than 20 at% and 70 at% or less, and a content of the first Cu-Ga alloy powder may be 5 mass% or more.

In this case, the content of the first Cu-Ga alloy powder having a Ga concentration in a range of more than 0 at% and 20 at% or less in the raw material powder is 5 mass% or more. Therefore, in the calcining step, under a low-temperature condition of less than 500°C, the first Cu-Ga alloy powder is preferentially reduced and necked such that the calcined material having a sufficient strength can be obtained.

In the method of manufacturing a Cu-Ga alloy sputtering target according to the present invention, a Ga content in the raw material powder may be 20 at% or more and 40 at% or less.

In this case, a Cu-Ga alloy sputtering target including a hollow portion that is suitable for manufacturing a CIGS solar cell can be manufactured.

In addition, in the method of manufacturing a Cu-Ga alloy sputtering target according to the present invention, sintering is performed under a temperature condition of (Tm-150)°C or more and less than Tm°C in the main sintering step, where Tm corresponds to a temperature, at which a liquid phase of the calcined Cu-Ga alloy appears under ordinary pressure, in Celsius.

In this case, the sintering density can be sufficiently improved by performing sintering in the temperature condition of (Tm-150)°C or more, where Tm corresponds to the temperature, at which the liquid phase of the calcined Cu-Ga alloy appears under ordinary pressure, in Celsius. In addition, the shape of the sintered material can be maintained by performing sintering in the temperature condition less than Tm°C.

According to another aspect of the present disclosure, which does not form part of the invention, there is provided a Cu-Ga alloy sputtering target (hereinafter, referred to as "the Cu-Ga alloy sputtering target according to the present invention") made of a Cu-Ga alloy, a hollow portion being formed therein, in which a ratio Fi/Fo of a bending strength Fi of an inside of the cylinder to a bending strength Fo of an outside of the cylinder is in a range of 0.980 or more and 1.020 or less.

According to the Cu-Ga alloy sputtering target having the above-described configuration, the ratio Fi/Fo of the bending strength Fi of the inside of the cylinder to the bending strength Fo of the outside of the cylinder is in a range of 0.980 or more and 1.020 or less. Therefore, there is no difference in the progress of sintering between the inside of the cylinder and the outside of the cylinder, and the structure is uniform as a whole. As a result, from the start to end of use of the target, stable sputtering characteristic (for example, input power or deposition rate) can be maintained, and thus a uniform sputtered film can be easily prepared.

In the Cu-Ga alloy sputtering target, a number density of pores having an equivalent circle diameter of less than 25 µm is 100 pores/mm² or less, a number density of pores having an equivalent circle diameter of 25 µm or more and 100 µm or less is 20 pores/mm² or less, and a number density of pores having an equivalent circle diameter of 100 µm or more is 2 pores/mm² or less.

In this case, the number density of pores having each of the sizes is set to be as described above. Therefore, a dispersion in the distribution of pores is small. Accordingly, a dispersion in characteristics as a whole of the Cu-Ga alloy sputtering target can be suppressed.

Further, in the Cu-Ga alloy sputtering target, it is preferable that a Ga concentration is in a range of 20 at% or more and 40 at% or less.

According to the Cu-Ga alloy sputtering target having the above-described configuration, the Ga concentration is in a range of 20 at% or more and 40 at% or less. Therefore, the Cu-Ga alloy sputtering target can be used as a target for manufacturing a CIGS solar cell.

In addition, in the Cu-Ga alloy sputtering target, it is preferable that a relative density is 90% or more.

According to the Cu-Ga alloy sputtering target having the above-described configuration, a relative density is 90% or more. Therefore, the occurrence of abnormal discharge during sputtering can be suppressed, and a film can be stably formed. Advantageous Effects of Invention

As described above, according to the present invention, it is possible to provide: a method of manufacturing a Cu-Ga alloy sputtering target in which a Cu-Ga alloy sputtering target including a hollow portion can be manufactured with a high production efficiency at low costs.

### Brief Description of Drawings

FIG. 1 is a schematic diagram showing a Cu-Ga alloy sputtering target not forming part of the invention, in which FIG. 1(a) is a cross-sectional view perpendicular to an axis direction, and FIG. 1 (b) is a side view.
FIG. 2 is a flowchart showing a method of manufacturing a Cu-Ga alloy sputtering target according to an embodiment of the present invention.
FIG. 3 is a schematic diagram showing the method of manufacturing a Cu-Ga alloy sputtering target according to the embodiment of the present invention.
FIG. 4 is an image showing the result of observing an internal structure of Example 2.
FIG. 5 is an image showing the result of observing an internal structure of Comparative Example 3.
FIG. 6 show images showing the results of observing pores in Example 2.
FIG. 7 show images showing the results of observing pores in Comparative Example 3.

### Description of Embodiments

Hereinafter, a method of manufacturing a Cu-Ga alloy sputtering target according to an embodiment of the present invention and a Cu-Ga alloy sputtering target according to an embodiment not forming part of the invention will be described with reference to the accompanying drawings.

The Cu-Ga alloy sputtering target 10 according to the embodiment is used when a Cu-Ga thin film is formed by sputtering in order to form, for example, a light-absorbing layer formed of a Cu-In-Ga-Se quaternary alloy thin film in a CIGS thin film solar cell.

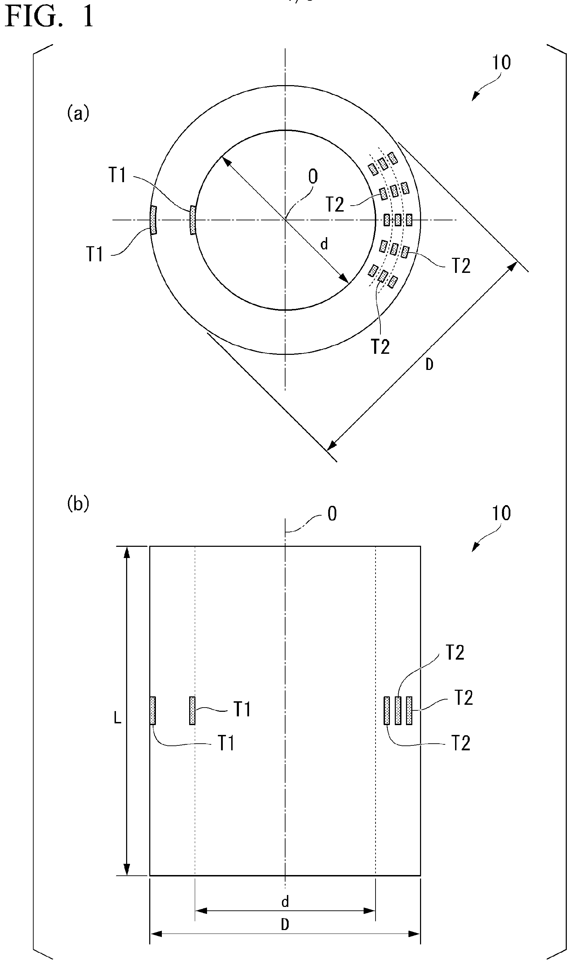

As shown in FIG. 1, the Cu-Ga alloy sputtering target 10 according to the embodiment includes a hollow portion. Specifically, the Cu-Ga alloy sputtering target 10 shown in FIG. 1 has a cylindrical shape that extends along an axis O, in which, for example, an outer diameter D is in a range of 150 mm≤D≤200 mm, an inner diameter d is in a range of 120 mm≤d≤190 mm, and a length L in the axis O direction is in a range of 200 mm≤L≤2000 mm.

Here, the outer peripheral surface of the Cu-Ga alloy sputtering target 10 is a sputtering surface. The hollow portion corresponds to a space surrounded by the inner peripheral surface of the Cu-Ga alloy sputtering target 10. The outer peripheral surface and the inner peripheral surface of the Cu-Ga alloy sputtering target 10 are concentrically formed.

In addition, in the Cu-Ga alloy sputtering target 10 according to the embodiment, a ratio Fi/Fo of a bending strength Fi of an inside of the cylinder to a bending strength Fo of an outside of the cylinder is in a range of 0.980 or more and 1.020 or less.

Further, in the Cu-Ga alloy sputtering target 10 according to the embodiment, a number density of pores having an equivalent circle diameter of less than 25 µm is 100 pores/mm² or less, a number density of pores having an equivalent circle diameter of 25 µm or more and 100 µm or less is 20 pores/mm² or less, and a number density of pores having an equivalent circle diameter of 100 µm or more is 2 pores/mm² or less.

In addition, the Cu-Ga alloy sputtering target 10 has a composition corresponding to a thin film to be formed and, in the embodiment, is made of a Cu-Ga alloy in which the Ga content is in a range of 20 at% or more and 40 at% or less and the balance includes Cu and inevitable impurities.

In addition, in the Cu-Ga alloy sputtering target 10, a relative density is 90% or more. Regarding the relative density, in a graph in which the vertical axis represents a density and the horizontal axis represents a Ga composition, a density ρ_{Cu} of pure copper of 8.96 g/cm³ and a density ρ_{CuGa} of the Cu-Ga alloy (Cu: 69.23 at%, Ga: 30.77 at%) of 8.47 g/cm³ are connected through a straight line, and a value obtained by interpolation or extrapolation according to the composition of the Cu-Ga alloy (Ga content) is calculated as 100%.

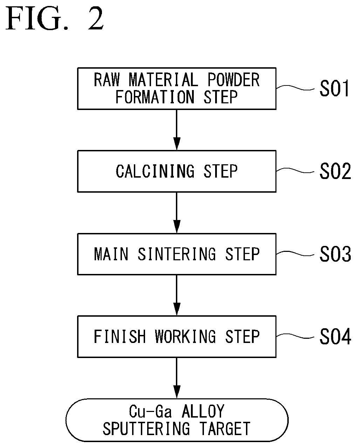

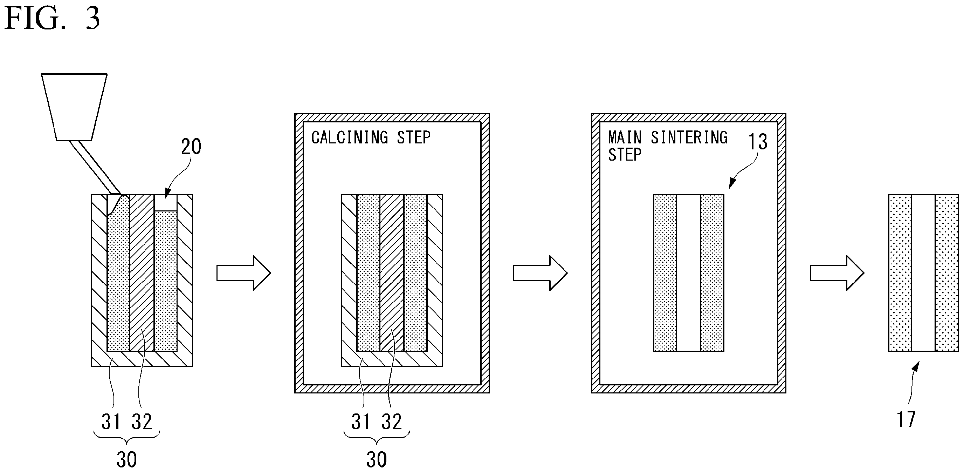

Next, the method of manufacturing the Cu-Ga alloy sputtering target 10 according to the embodiment will be described with reference to FIGS. 2 and 3.

As shown in FIG. 2, the method of manufacturing the Cu-Ga alloy sputtering target 10 according to the embodiment includes: a raw material powder formation step S01 of obtaining raw material powder 20 by mixing Cu powder and Cu-Ga alloy powder; a calcining step S02 of forming a calcined material 13 by charging the raw material powder 20 obtained in the raw material powder formation step S01 into a mold 30 including a core 32 and heating the raw material powder 20 in a reducing atmosphere; a main sintering step S03 of forming a sintered material 17 by removing the core 32 from the calcined material 13 and heating the calcined material 13 in a reducing atmosphere; and a finish working step S04 of finishing the obtained sintered material 17.

### (Raw material powder Preparing Step S01)

First, the raw material powder 20 that includes at least a Cu-Ga alloy powder is prepared. The raw material powder 20 may include 5 mass% or more of a Cu powder in addition to the Cu-Ga alloy powder. The raw material powder 20 may be formed of mixed powder of the first Cu-Ga alloy powder having a Ga concentration in a range of more than 0 at% and 20 at% or less and the second Cu-Ga alloy powder having a Ga concentration in a range of more than 20 at% and 70 at% or less, in which a content of the first Cu-Ga alloy powder is 5 mass% or more. The raw material powder 20 may be formed of only Cu-Ga alloy powder having a single composition. The raw material powder 20 may be purchased, may be mixed with purchased raw material powder, or may be manufactured using, for example, the following atomizing method.

A massive Cu raw material and a massive Ga raw material are weighed to obtain a predetermined composition and are put into a crucible formed of carbon, and this crucible is set in a gas atomization device. The raw materials are melted by being held under a temperature condition of 1000°C or more and 1200°C or less for 1 minute or more and 30 minutes or less by evacuation. Next, while causing the molten alloy to drop through nozzles having a pore size of 1 mm or more and 3 mm or less, Ar gas is injected at a gas injection pressure of 10 kgf/cm² or more and 50 kgf/cm₂ or less. As a result, gas atomized powder is prepared. The obtained gas atomized powder is cooled and then classified through a sieve. As a result, Cu-Ga alloy powder having a predetermined grain size is obtained. Depending on the composition ratio between Cu and Ga, due to its high injection temperature, the molten alloy may reach a chamber before solidified into powder. In this case, it is preferable that the injection temperature is set to be less than a heating and holding temperature by about 100°C to 400°C.

The Ga content in the raw material powder 20 is a predetermined value (in the embodiment, Ga content: 20 at% or more and 40 at% or less). In addition, it is preferable that the raw material powder 20 is mixed using a mixer such as a Henschel mill.

### (Calcining step S02)

Next, the raw material powder 20 obtained in the raw material powder formation step S01 is charged into the mold 30 including the core 32 and is heated in a reducing atmosphere. As a result, the raw material powder 20 is sintered to have a strength with which the shape can be maintained, and thus the calcined material 13 is obtained. It is preferable that a relative density in the calcined material 13 is 30% or more and 70% or less.

The mold 30 used in the calcining step S02 includes: an outer mold 31; and the core 32 that is disposed in the outer mold 31. The outer mold 31 and the core 32 are formed of a material having heat resistance at the holding temperature in the calcining step S02. In the embodiment, the outer mold is made of carbon, and the core is made of aluminum, zinc, or stainless steel.

The core 32 is made of a material having a higher linear thermal expansion coefficient than the Cu-Ga alloy to be manufactured. In the embodiment, the core 32 is made of a material having a linear thermal expansion coefficient of 15×10⁻⁶/°C or more. The upper limit of the linear thermal expansion coefficient of the core 32 is not particularly limited and is preferably 45×10⁻⁶/°C or less. When expressed in units of "/°C", the linear thermal expansion coefficient of the core 32 is preferably 100% or more with respect to the linear thermal expansion coefficient of the Cu-Ga alloy to be manufactured.

In addition, an inner diameter of the outer mold 31 is 150 mm or more and 300 mm or less, an outer diameter of the core 32 is 100 mm or more and 200 mm or less, a difference between the inner diameter of the outer mold 31 and the outer diameter of the core 32 is 10 mm or more and 200 mm or less, and a length in the axis direction is 50 mm or more and 3000 mm or less.

Here, in the calcining step S02, the holding temperature is set to be 100°C or more and 600°C or less, and the holding time is set to be 10 minutes or more and 10 hours or less.

In a case where the holding temperature is less than 100°C and the holding time is shorter than 10 minutes in the calcining step S02, the Cu powder is not reduced and does not form a neck portion. Therefore, the strength of the calcined material 13 may be insufficient. On the other hand, in a case where the holding temperature is more than 600°C and the holding time is longer than 10 hours, sintering progresses, and it is difficult to remove the core 32 due to sintering shrinkage. In addition, in a case where sintering excessively progresses in the calcining step S02, the calcined material 13 cannot be reduced up to the inside in the subsequent main sintering step S03, and thus the relative density of the sintered material 17 may decrease.

Therefore, in the embodiment, in the calcining step S02, the holding temperature is set to be 100°C or more and 600°C or less and the holding time is set to be 10 minutes or more and 10 hours or less.

In order to secure the strength of the calcined material 13, the holding temperature in the calcining step S02 is preferably 200°C or more. In addition, the holding time in the calcining step S02 is preferably 60 minutes or longer.

In addition, in order to suppress the excessive progress of sintering in the calcining step S02, the holding temperature in the calcining step S02 is preferably 500°C or less. In addition, the holding time in the calcining step S02 is preferably 180 minutes or shorter.

Further, the holding temperature and the holding time in the calcining step S02 is preferably set such that a relationship between the holding temperature T and the holding time H satisfies a curve T=0.0004×H²-0.6833×H+264 and T=0.0013×H²-2.05×H+792. As a result, a calcined material having an effective porosity for reducing the raw material powder can be prepared. The reason for this is follows. Since the rate of progress of sintering varies depending on the temperature, it is necessary that sintering is performed at a high temperature for a short time or at a low temperature for a long time in order to obtain a low porosity.

Further, in the calcining step S02, the raw material powder is heated in a reducing atmosphere such as hydrogen, ammonia decomposition gas, or CO gas, and the oxygen concentration in the atmosphere is less than 10 vol%. In a case where the oxygen concentration in the atmosphere is 10 vol% or more, the reduction of the Cu powder and the Cu-Ga alloy powder is not sufficient, and the strength of the calcined material 13 may be insufficient. Therefore, the oxygen concentration in the atmosphere is set to be less than 10 vol%.

In the embodiment, mainly, the calcining step S02 is performed in a hydrogen atmosphere (purity: 90 vol% or more, dew point: -50°C or less).

### (Main Sintering Step S03)

After the calcining step S02 ends, the core 32 is removed from the obtained calcined material 13, and the calcined material 13 is extracted from the mold 30. The calcined material 13 is heated in a reducing atmosphere to be sintered, and thus the sintered material 17 is obtained.

Here, in the main sintering step S03, in a case where a liquid phase appearance temperature of the Cu-Ga alloy to be manufactured under a normal pressure (1.00 to 1.05 atm) is represented by Tm°C, sintering is performed under a temperature condition of (Tm-150)°C or more and less than Tm°C.

In a case where the holding temperature in the main sintering step S03 is less than (Tm-50)°C, the relative density of the sintered material 17 may be insufficient. On the other hand, in a case where the holding temperature in the main sintering step S03 is Tm°C or more, the amount of liquid phase formed is more than necessary, and thus there may be a case where the shape of the sintered material 17 cannot be maintained.

Therefore, in the embodiment, the holding temperature in the main sintering step S03 is set to be (Tm-150)°C or more and less than Tm°C.

In order to reliably improve the relative density of the sintered material 17, the holding temperature in the main sintering step S03 is preferably (Tm-120)°C or more and more preferably (Tm-100)°C or more. On the other hand, in order to reliably retain the shape of the sintered material 17, the holding temperature in the main sintering step S03 is preferably (Tm-5)°C or less and more preferably (Tm-20)°C or less.

In addition, the sintering time in the main sintering step S03 is preferably 10 minutes or more and 20 minutes or less and more preferably 60 minutes or more and 10 hours or less.

Further, in the main sintering step S03, the raw material powder is heated in a reducing atmosphere such as hydrogen, ammonia decomposition gas, or CO gas, and the oxygen concentration in the atmosphere is less than 10 vol%. In a case where the oxygen concentration in the atmosphere is 10 vol% or more, the reduction of the Cu powder and the Cu-Ga alloy powder is not sufficient, and the strength of the sintered material 17 may be insufficient. Therefore, the oxygen concentration in the atmosphere is set to be less than 10 vol%.

In the embodiment, mainly, the main sintering step S03 is performed in a hydrogen atmosphere (purity: 90 vol% or more, dew point: -50°C or less).

### (Finish Working S04)

A sputtering target having a predetermined shape is obtained by cutting or grinding the sintered material 17 obtained in the main sintering step S03.

Through the above-described steps, the Cu-Ga alloy sputtering target 10 according to the embodiment is manufactured.

According to the method of manufacturing the Cu-Ga alloy sputtering target 10 according to the embodiment having the above-described configuration and the Cu-Ga alloy sputtering target 10, the method includes: the calcining step S02 of forming the calcined material 13 by charging the raw material powder 20 into the mold 30 including the core 32 and heating the raw material powder 20 in a reducing atmosphere; and the main sintering step S03 of forming the sintered material 17 by removing the core 32 from the obtained calcined material 13 and heating the calcined material 13 in a reducing atmosphere. Therefore, it is not necessary to use a pressing device or the like, the cylindrical sintered material 17 can be obtained, the manufacturing costs can be reduced, and the production efficiency can be improved.

In addition, the main sintering step S03 is provided after the calcining step S02. Therefore, in the calcining step S02, the raw material powder 20 may be sintered to have a strength with which the shape can be maintained, and thus the amount of shrinkage in the calcining step S02 can be suppressed. In addition, the core 32 can be relatively simply removed.

Further, the number of pores in the calcined material 13 is large, the reducing gas can be caused to sufficiently flow to the inside of the cylinder and the outside of the cylinder of the calcined material 13 in the main sintering step S03, and a difference in the progress of sintering between the inside of the cylinder and the outside of the cylinder of the calcined material 13 can be suppressed. As a result, the Cu-Ga alloy sputtering target 10 in which a ratio Fi/Fo of a bending strength Fi of an inside of the cylinder to a bending strength Fo of an outside of the cylinder is in a range of 0.980 or more and 1.020 or less can be manufactured.

In addition, in the calcining step S02, the core 32 made of a material having a higher linear thermal expansion coefficient than the Cu-Ga alloy to be manufactured is used. Therefore, during cooling after the calcining step S02, the core 32 significantly shrinks, and the core 32 can be easily removed from the calcined material 13. Accordingly, damages of the calcined material 13 can be suppressed.

Further, in the calcining step S02, the holding temperature is 100°C or more, and the holding time is 10 minutes or longer. Therefore, the strength of the calcined material 13 is secured, and damages of the calcined material 13 during handling such as the subsequent main sintering step S03 can be suppressed. In addition, the holding temperature in the calcining step S02 is less than 800°C. Therefore, sintering in the calcining step S02 can be suppressed from progressing more than necessary. In the subsequent main sintering step S03, the calcined material 13 can be reliably sintered up to the inside, and the sintered material 17 having a high relative density can be obtained.

In addition, in the raw material powder formation step S01, a mixing ratio between the Cu powder and the Cu-Ga alloy powder is adjusted such that the content of the Cu powder is 5 mass% or more. Therefore, in the calcining step S02, under a low-temperature condition, the Cu powder is preferentially reduced and necked such that the calcined material 13 having a sufficient strength can be obtained.

In addition, in the main sintering step S03, in a case where the liquid phase appearance temperature of the Cu-Ga alloy to be manufactured is represented by Tm°C, the holding temperature is set in a range of (Tm-150)°C or more and less than Tm°C. Therefore, the relative density of the sintered material 17 can be sufficiently improved, and the shape of the sintered material 17 can be maintained.

Further, in the embodiment, in the calcining step S02 and the main sintering step S03, the raw material powder is heated in a reducing atmosphere such as hydrogen, ammonia decomposition gas, or CO gas, and the oxygen concentration in the atmosphere is less than 10 vol%. Therefore, the raw material powder 20 is reduced, and the sintered material 17 can be reliably manufactured.

In addition, in the Cu-Ga alloy sputtering target 10 according to the embodiment, a ratio Fi/Fo of a bending strength Fi of an inside of the cylinder to a bending strength Fo of an outside of the cylinder is in a range of 0.980 or more and 1.020 or less. Therefore, there is no difference in the progress of sintering between the inside of the cylinder and the outside of the cylinder, and the structure is uniform as a whole.

Further, in the Cu-Ga alloy sputtering target 10 according to the embodiment, a number density of pores having an equivalent circle diameter of less than 20 µm is 100 pores/mm² or less, a number density of pores having an equivalent circle diameter of 20 µm or more and 100 µm or less is 20 pores/mm² or less, and a number density of pores having an equivalent circle diameter of 100 µm or more is 2 pores/mm² or less. Therefore, a dispersion in the distribution of pores is small, and a dispersion in characteristics as a whole of the Cu-Ga alloy sputtering target 10 can be suppressed.

Further, in the Cu-Ga alloy sputtering target 10 according to the embodiment, the relative density is 90% or more. The number of pores which cause abnormal discharge is small, and a film can be stably formed.

Hereinabove, the embodiment of the present invention has been described. However, the present invention is not limited to the embodiment, and various modifications can be made within a range not departing from the technical ideas of the present invention.

For example, in the description of the embodiment relating to the method of manufacturing the Cu-Ga sputtering target, the Cu-Ga alloy sputtering target has the composition in which the Ga content is in a range of 20 at% or more and 40 at% or less, and a balance includes Cu and inevitable impurities. However, the embodiment is not limited to this configuration, and the Cu-Ga alloy sputtering target may include additive elements such as alkali metal other than Cu and Ga.

Further, the dimension or shape of the mold (core) is not limited to the embodiment, and the design thereof may be appropriately changed according to the shape or size of the Cu-Ga alloy sputtering target to be manufactured.

In addition, in the description of the embodiment, the sintered material having a cylindrical shape is manufactured, and the Cu-Ga alloy sputtering target having a cylindrical shape is manufactured from the sintered material. However, the embodiment is not limited to this configuration, a sintered material including a hollow portion may be manufactured using a core.

### [Examples]

Hereinafter, the result of an evaluation test for evaluating the method of manufacturing a Cu-Ga alloy sputtering target according to the present invention will be described.

First, Cu-Ga alloy powder and Cu powder were prepared as raw material powder, were weighed to obtain a composition shown in Table 1, and were mixed using a Henschel mill. At this time, the content of the Cu powder in the raw material powder was adjusted as shown in Table 1.

The raw material powder was charged into a mold including a core. An outer mold of the mold was formed of carbon, and the core was formed of a material shown in Table 2. The dimension of a cavity partitioned by the outer mold and the core had an outer diameter of 230 mm, an inner diameter of 170 mm, and a length of 300 mm in an axis direction.

A calcined material was obtained by performing a calcining step in an atmosphere at a holding temperature for a holding time as shown in Table 2. In Comparative Example 3, the outer mold was formed of SUS410 because the calcining step was performed in the air atmosphere.

Next, the core was removed from the calcined material, the calcined material was extracted from the mold, and the main sintering step was performed under conditions shown in Table 2.

As described above, regarding the obtained sintered material, the composition of the sintered material, whether or not cracking occurred in the manufacturing steps, the relative density, the oxygen concentration, and the internal structure were evaluated as described below.

### <Composition of Sintered material>

As a result of measurement using a high-frequency inductively coupled plasma method (ICP method), it was found that the composition of the sintered material was substantially the same as the theoretical composition of the raw material powder.

### <Cracking of Sintered material>

In the calcining step, the main sintering step, and the like, whether or not cracking occurred in the sintered material was determined by visual inspection. The evaluation results are shown in Table 3.

### <Relative Density>

Regarding the obtained sintered material, the weight was divided by the volume to obtain the density. In a graph in which the vertical axis represents a density and the horizontal axis represents a Ga content, a density ρ_{Cu} of pure copper of 8.96 g/cm³ and a density ρ_{CuGa} of the Cu-Ga alloy (Cu: 69.23 at%, Ga: 30.77 at%) of 8.47 g/cm³ were connected through a straight line, and a value obtained by interpolation or extrapolation according to the Ga content of the Cu-Ga alloy was calculated as 100%. Based on the obtained value, a relative density was calculated. The evaluation results are shown in Table 3.

### <Oxygen Concentration>

The oxygen concentration of the obtained sintered material was measured using an infrared absorption method described in "General Rules for Determination of Oxygen in Metallic Materials" of JIS Z 2613. The evaluation results are shown in Table 3.

### <Internal Structure>

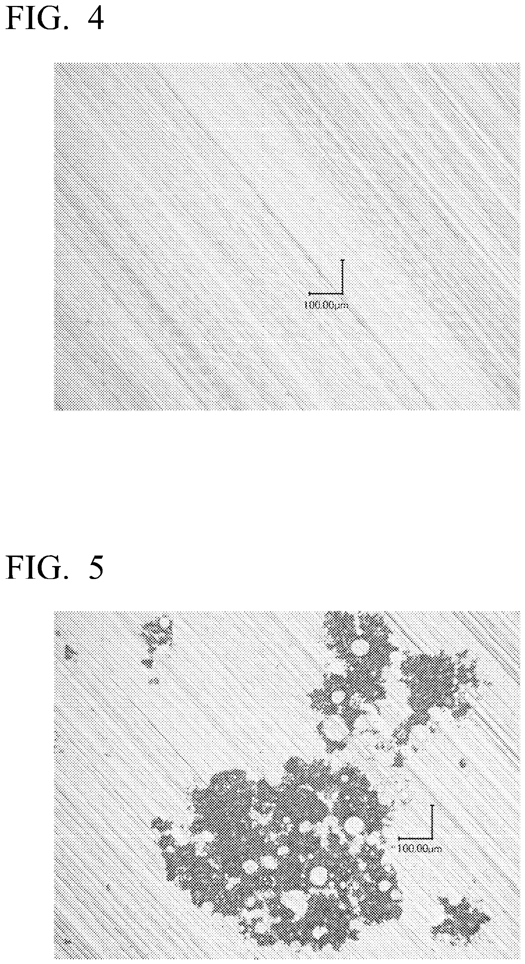

A measurement sample was collected from a position indicated by T1 in FIG. 1 in the cylindrical sintered material, an observation surface was polished and etched and then was observed using an optical microscope. In the observation, the magnification was 250 times, and the total observation field area was 12 mm² or more. The measurement sample was collected from 10 positions of the sintered material. Whether or not a non-sintered portion was present in the observation field was determined. The evaluation results are shown in Table 3. In addition, FIG. 4 shows the observation result of Example 2, and FIG. 5 shows the observation result of Comparative Example 3.

### <Distribution of Pores>

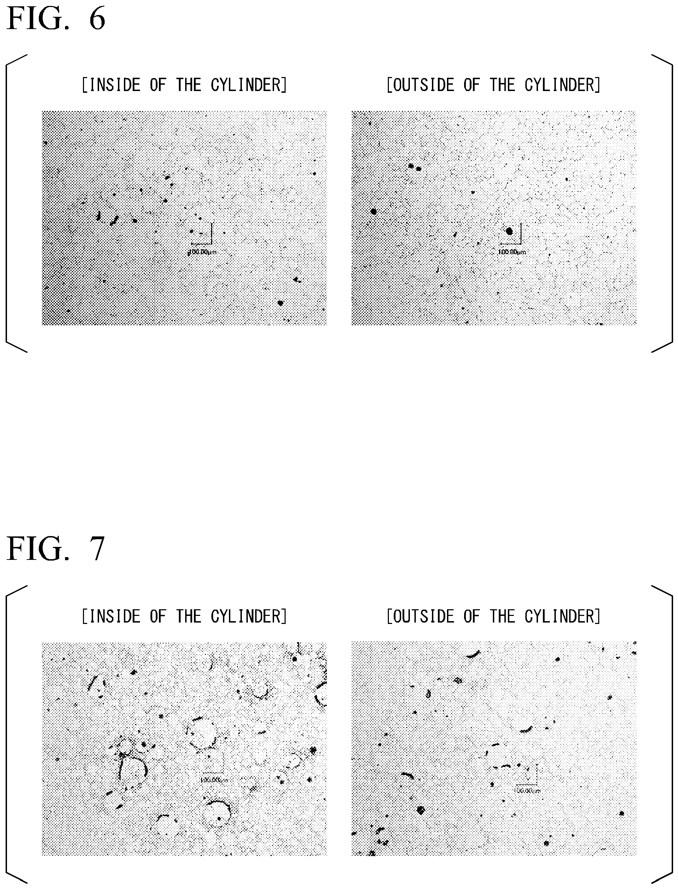

A measurement sample was collected from a position indicated by T1 in FIG. 1 in the cylindrical sintered material, the inner peripheral surface and the outer peripheral surface of the target as observation surfaces were polished and etched and then was observed using an optical microscope. In the observation, the magnification was 250 times, and the total observation field area was 7.5 mm² or more. The measurement sample was collected from 10 positions of the sintered material. The number density of pores having an equivalent circle diameter of less than 25 µm, the number density of pores having an equivalent circle diameter of 25 µm or more and 100 µm or less, and the number density of pores having an equivalent circle diameter of 100 µm or more were evaluated. The evaluation results are shown in Table 3. In addition, FIG. 6 shows the results of observing the inside of the cylinder and the outside of the cylinder of Example 2, and FIG. 7 shows the results of observing the inside of the cylinder and the outside of the cylinder of Comparative Example 3.

### <Bending Strength>

As shown in FIG. 1, the cylindrical sintered material was divided into three portions in a radial direction, five specimens (3 mm×4 mm×35 mm) were collected from each of thickness center portions (position indicated by T2 in FIG. 1) of the inside of the cylinder and the outside of the cylinder, and a stress trajectory was measured at an indentation speed of 0.5 mm/min using Autograph AG-X (manufactured by Shimadzu Corporation). A maximum point stress of an elastic area was obtained, and the bending strength was evaluated based on the average value of the five specimens. The evaluation results are shown in Table 3.

**[Table 1]**

| | Composition(at%) | | Liquid Phase Appearance Temperature (°C) | Content of Cu Powder (mass%) | Cu-Ga alloy Powder | | First Cu-Ga alloy Powder | | Second Cu-Ga alloy Powder | |
|---|---|---|---|---|---|---|---|---|---|---|
| | Ga | Cu | | | Content (mass%) | Ga Composition (at%) | Content (mass%) | Ga Composition (at%) | Content (mass%) | Ga Composition (at%) |
| Example 1 of the present invention | 20 | Balance | 915 | 57 | 43 | 47.7 | - | - | - | - |
| Example 2 of the present invention | 30 | Balance | 836 | 36 | 64 | 47.7 | - | - | - | - |
| Example 3 of the present invention | 40 | Balance | 400 | 15 | 85 | 47.4 | - | - | - | - |
| Example 4 of the present invention | 30 | Balance | 836 | 6 | 94 | 32.0 | - | - | - | - |
| Example 5 of the present invention | 30 | Balance | 836 | 67 | 33 | 96.5 | - | - | - | - |
| Example 6 of the present invention | 30 | Balance | 836 | 36 | 64 | 47.7 | - | - | - | - |
| Example 7 of the present invention | 30 | Balance | 836 | 36 | 64 | 47.7 | - | - | - | - |
| Example 8 of the present invention | 30 | Balance | 836 | 36 | 64 | 47.7 | - | - | - | - |
| Example 9 of the present invention | 30 | Balance | 836 | 36 | 64 | 47.7 | - | - | - | - |
| Example 10 of the present invention | 30 | Balance | 836 | 36 | 64 | 47.7 | - | - | - | - |
| Example 11 of the present invention | 30 | Balance | 836 | 36 | 64 | 47.7 | - | - | - | - |
| Example 12 of the present invention | 30 | Balance | 836 | 36 | 64 | 47.7 | - | - | - | - |
| Example 13 of the present invention | 30 | Balance | 836 | 0 | 100 | 30.0 | - | - | - | - |
| Example 14 of the present invention | 30 | Balance | 836 | - | - | - | 6.3 | 1.0 | 93.7 | 32.0 |
| Comparative Example 1 | 30 | Balance | 836 | 36 | 64 | 47.7 | - | - | - | - |
| Comparative Example 2 | 30 | Balance | 836 | 36 | 64 | 47.7 | - | - | - | - |
| Comparative Example 3 | 30 | Balance | 836 | 36 | 64 | 47.7 | - | - | - | - |
| Comparative Example 4 | 30 | Balance | 836 | 36 | 64 | 47.7 | - | - | - | - |
| Comparative Example 5 | 30 | Balance | 836 | 36 | 64 | 47.7 | - | - | - | - |

**[Table 2]**

| | Core | | Atmosphere | Calcining step | | Main Sintering Step | |
|---|---|---|---|---|---|---|---|
| | Material | Linear Thermal Expansion Coefficient | | Temperature (°C) | Time (min) | Temperature (°C) | Time (min) |
| Example 1 of the present invention | Aluminum | 23 | Hydrogen | 400 | 60 | 830 | 300 |
| Example 2 of the present invention | Aluminum | 23 | Hydrogen | 400 | 60 | 800 | 300 |
| Example 3 of the present invention | Aluminum | 23 | Hydrogen | 200 | 60 | 380 | 300 |
| Example 4 of the present invention | Aluminum | 23 | Hydrogen | 400 | 60 | 800 | 300 |
| Example 5 of the present invention | Aluminum | 23 | Hydrogen | 400 | 60 | 800 | 300 |
| Example 6 of the present invention | Zinc | 26 | Hydrogen | 300 | 120 | 800 | 300 |
| Example 7 of the present invention | SUS304 | 17 | Hydrogen | 400 | 60 | 800 | 300 |
| Example 8 of the present invention | Aluminum | 23 | Co | 400 | 60 | 800 | 300 |
| Example 9 of the present invention | Aluminum | 23 | Ammonia Decomposition Gas | 400 | 60 | 800 | 300 |
| Example 10 of the present invention | Aluminum | 23 | Hydrogen | 400 | 60 | 800 | 300 |
| Example 11 of the present invention | Aluminum | 23 | Hydrogen | 100 | 600 | 800 | 300 |
| Example 12 of the present invention | SUS304 | 17 | Hydrogen | 600 | 30 | 800 | 300 |
| Example 13 of the present invention | Aluminum | 23 | Hydrogen | 500 | 60 | 800 | 300 |
| Example 14 of the present invention | Aluminum | 23 | Hydrogen | 400 | 60 | 800 | 300 |
| Comparative Example 1 | Carbon | 6 | Hydrogen | 400 | 60 | - | - |
| Comparative Example 2 | Aluminum | 23 | Air | 400 | 60 | 800 | 300 |
| Comparative Example 3 | Aluminum | 23 | Hydrogen | 50 | 600 | - | - |
| Comparative Example 4 | Aluminum | 23 | Hydrogen | 400 | 5 | - | - |
| Comparative Example 5 | Aluminum | 23 | Hydrogen | 400 | 60 | 650 | 300 |

**[Table 3]**

| | Evaluation of Sintered material | | | | | | | | | |
|---|---|---|---|---|---|---|---|---|---|---|
| | Cracking | Relative Density (%) | Oxygen Concentration (ppm) | Internal Structure | Number Density | of Pores (pores/mm²) | | Bending Strength (MPa) | | |
| | | | | | 25µm< | 25-100µm | ≥100µm | Inside of the cylinder | Outside of the cylinder | Fi/Fo |
| Example 1 of the present invention | Not Occurred | 98 | 80 | No Problem | 30.1 | 2.4 | 0.0 | 296 | 294 | 1.007 |
| Example 2 of the present invention | Not Occurred | 97 | 70 | No Problem | 21.1 | 2.6 | 0.0 | 232 | 233 | 0.996 |
| Example 3 of the present invention | Not Occurred | 95 | 65 | No Problem | 21.6 | 2.7 | 0.0 | 153 | 154 | 0.994 |
| Example 4 of the present invention | Not Occurred | 93 | 55 | No Problem | 33.3 | 5.1 | 0.2 | 227 | 227 | 1.000 |
| Example 5 of the present invention | Not Occurred | 98 | 85 | No Problem | 28.7 | 4.5 | 0.0 | 241 | 239 | 1.008 |
| Example 6 of the present invention | Not Occurred | 96 | 70 | No Problem | 25.6 | 4.8 | 0.1 | 233 | 232 | 1.004 |
| Example 7 of the present invention | Not Occurred | 97 | 70 | No Problem | 17.8 | 3.9 | 0.0 | 231 | 232 | 0.996 |
| Example 8 of the present invention | Not Occurred | 92 | 95 | No Problem | 19.6 | 5.0 | 0.3 | 216 | 215 | 1.005 |
| Example 9 of the present invention | Not Occurred | 91 | 95 | No Problem | 25.4 | 5.6 | 0.5 | 207 | 209 | 0.990 |
| Example 10 of the present invention | Not Occurred | 92 | 75 | No Problem | 30.2 | 4.9 | 0.2 | 223 | 222 | 1.005 |
| Example 11 of the present invention | Not Occurred | 95 | 70 | No Problem | 30.1 | 4.4 | 0.0 | 228 | 229 | 0.996 |
| Example 12 of the present invention | Not Occurred | 97 | 70 | No Problem | 34.0 | 4.5 | 0.0 | 231 | 233 | 0.991 |
| Example 13 of the present invention | Not Occurred | 96 | 55 | No Problem | 31.5 | 19.3 | 0.2 | 210 | 214 | 0.981 |
| Example 14 of the present invention | Not Occurred | 94 | 55 | No Problem | 30.8 | 10.5 | 0.5 | 215 | 217 | 0.991 |
| Comparative Example I | Occurred | - | - | - | - | - | - | - | - | - |
| Comparative Example 2 | Not Occurred | 80 | - | Non-Sintered Portion Present | Unmeasurable | 54.8 | 2.2 | 56 | 42 | 1.333 |
| Comparative Example 3 | Occurred | - | - | - | - | - | - | - | - | - |
| Comparative Example 4 | Occurred | - | - | - | - | - | - | - | - | - |
| Comparative Example 5 | Not Occurred | 89 | 110 | - | 21.9 | 15.2 | 2.1 | 158 | 170 | 0.929 |

In Comparative Example 1 in which the core which was formed of carbon having a linear thermal expansion coefficient of 6×10⁻⁶/°C less than the linear thermal expansion coefficient of the Cu-Ga alloy (about 15×10⁻⁶/°C), cracking occurred in the calcining step.

In Comparative Example 2, in which the calcining step and the main sintering step were performed in the air atmosphere, as shown in FIG. 5, a non-sintered portion was observed in the sintered material. In addition, the relative density was low at 80%. Further, a ratio Fi/Fo of the bending strength Fi of the inside of the cylinder to the bending strength Fo of the outside of the cylinder was 1.33, and there was a difference in bending strength. Further, the number of pores was large.

In Comparative Example 3 in which the holding temperature in the calcining step was 50°C and Comparative Example 4 in which the holding time in the calcining step was 5 min, cracking occurred in the calcined material during handling. Therefore, main sintering was not performed. It is determined that the reason for this was that sintering did not sufficiently progress in the calcining step.

In addition, in Comparative Example 5, as shown in FIG. 7, there was a large difference in the distribution of pores between the inside of the cylinder and the outside of the cylinder, and there was also a large difference in bending strength therebetween.

On the other hand, in Examples in which the content of the Cu powder in the raw material powder, the holding temperature and the holding time in the calcining step, and the linear expansion thermal coefficient of the core were set in the ranges of the present invention, cracking or the like did not occur, and a non-sintered portion was not observed in the sintered material as shown in FIG. 4. In addition, in all the Examples, the relative density was 90% or more.

In addition, in Examples, as shown in FIG. 6, there was a small difference in the distribution of pores between the inside of the cylinder and the outside of the cylinder, a ratio Fi/Fo of the bending strength Fi of the inside of the cylinder to the bending strength Fo of the outside of the cylinder was in a range of 0.980 or more and 1.020 or less, and there was a small difference in bending strength. In addition, the number of pores was small, and there was a small dispersion in the distribution of pores.

Based on the above results, it was found that, according to the present invention, a Cu-Ga alloy sputtering target including a hollow portion can be manufactured with a high production efficiency at low costs. In addition, it was found that a Cu-Ga alloy sputtering target having a small difference in characteristics between the inside of the cylinder and the outside of the cylinder can be provided.

### Industrial Applicability

The production efficiency of a cylindrical Cu-Ga alloy sputtering target required to form a Cu-In-Ga-Se quaternary alloy thin film using a selenization method increases, and the manufacturing costs thereof are also reduced. As a result, a CIGS solar cell can be manufactured with higher efficiency at lower costs.

### Reference Signs List

10: Cu-Ga ALLOY SPUTTERING TARGET
13: CALCINED MATERIAL
20: RAW MATERIAL POWDER
30: MOLD
32: CORE
S01: RAW MATERIAL POWDER FORMATION STEP
S02: CALCINING STEP
S03: MAIN SINTERING STEP

## Claims

1. A method of manufacturing a Cu-Ga alloy sputtering target made of a Cu-Ga alloy, a hollow portion being formed therein, the method comprising:
a calcining step of forming a calcined material by charging a raw material powder that includes at least a Cu-Ga alloy powder into a mold that includes a core and heating the raw material powder in a reducing atmosphere; and
a main sintering step of forming a sintered material by removing the core from the calcined material and heating the calcined material in a reducing atmosphere,
wherein the core used in the calcining step is made of a material having a higher linear thermal expansion coefficient than a Cu-Ga alloy constituting the Cu-Ga alloy sputtering target,
the calcined material is formed by holding the raw material powder at a temperature of 100°C or more and 600°C or less for 10 minutes or more and 10 hours or less in the calcining step, and
the main sintering step is performed under a temperature condition of (Tm-150)°C or more and less than Tm°C in the main sintering step, where Tm corresponds to a temperature, at which a liquid phase of the calcined Cu-Ga alloy appears under a pressure of 101 to 106 kPa (1.00 to 1.05 atm), in degree Celsius.

2. The method of manufacturing a Cu-Ga alloy sputtering target according to claim 1,
wherein the raw material powder includes a Cu powder and the Cu-Ga alloy powder, and a content of the Cu powder is 5 mass% or more.

3. The method of manufacturing a Cu-Ga alloy sputtering target according to claim 1,
wherein the raw material powder includes a first Cu-Ga alloy powder having a Ga concentration in a range of more than 0 at% and 20 at% or less and a second Cu-Ga alloy powder having a Ga concentration in a range of more than 20 at% and 70 at% or less, and a content of the first Cu-Ga alloy powder is 5 mass% or more.

4. The method of manufacturing a Cu-Ga alloy sputtering target according to any one of claims 1 to 3,
wherein a Ga content in the raw material powder is 20 at% or more and 40 at% or less.

## Patentansprüche

1. Verfahren zur Herstellung eines aus einer Cu-Ga-Legierung gefertigten Cu-Ga-Legierungs-Sputtertargets, in dem ein hohler Abschnitt ausgebildet ist, wobei das Verfahren folgendes umfasst:
einen Kalzinierungsschritt zur Bildung eines kalzinierten Materials durch Einfüllen eines Ausgangsmaterialpulvers, das mindestens ein Cu-Ga-Legierungspulver enthält, in eine Form, die einen Kern enthält, und Erhitzen des Ausgansmaterialpulvers in einer reduzierenden Atmosphäre; und
einen Hauptsinterschritt zur Bildung eines Sintermaterials durch Entfernen des Kerns aus dem kalzinierten Material und Erhitzen des kalzinierten Materials in einer reduzierenden Atmosphäre,
wobei der in dem Kalzinierungsschritt verwendete Kern aus einem Material hergestellt ist, das einen höheren linearen Wärmeausdehnungskoeffizienten als eine Cu-Ga-Legierung, die das Cu-Ga-Legierungs-Sputtertarget bildet, aufweist,
das kalzinierte Material durch Halten des Ausgangsmaterialpulvers bei einer Temperatur von 100 °C oder mehr und 600 °C oder weniger für 10 Minuten oder mehr und 10 Stunden oder weniger in dem Kalzinierungsschritt gebildet wird, und
der Hauptsinterschritt bei einer Temperaturbedingung von (Tm-150)°C oder mehr und weniger als Tm°C in dem Hauptsinterschritt, wobei Tm einer Temperatur in Grad Celsius entspricht, bei der eine flüssige Phase der kalzinierten Cu-Ga-Legierung bei einem Druck von 101 bis 106 kPa (1,00 bis 1,05 atm) auftritt, durchgeführt wird.

2. Verfahren zur Herstellung eines Cu-Ga-Legierungs-Sputtertargets gemäß Anspruch 1,
bei dem das Ausgangsmaterialpulver ein Cu-Pulver und das Cu-Ga-Legierungspulver enthält und der Gehalt des Cu-Pulvers 5 Massen-% oder mehr beträgt.

3. Verfahren zur Herstellung eines Cu-Ga-Legierungs-Sputtertargets gemäß Anspruch 1,
bei dem das Ausgangsmaterialpulver ein erstes Cu-Ga-Legierungspulver, das eine Ga-Konzentration in einem Bereich von mehr als 0 Atom-% und 20 Atom-% oder weniger aufweist, und ein zweites Cu-Ga-Legierungspulver, das eine Ga-Konzentration in einem Bereich von mehr als 20 Atom-% und 70 Atom-% oder weniger aufweist, enthält und der Gehalt des ersten Cu-Ga-Legierungspulvers 5 Massen-% oder mehr beträgt.

4. Verfahren zur Herstellung eines Cu-Ga-Legierungs-Sputtertargets gemäß mindestens einem der Ansprüche 1 bis 3,
bei dem der Ga-Gehalt in dem Ausgangsmaterialpulver 20 Atom-% oder mehr und 40 Atom-% oder weniger beträgt.

## Revendications

1. Procédé de fabrication d'une cible de pulvérisation en alliage Cu-Ga composée d'un alliage Cu-Ga, une partie creuse étant formée en son sein, le procédé comprenant :
une étape de calcination consistant à former un matériau calciné en chargeant une poudre de matière première qui inclut au moins une poudre d'alliage Cu-Ga dans un moule qui inclut un noyau, et à chauffer la poudre de matière première dans une atmosphère réductrice ; et
une étape de frittage principal consistant à former un matériau fritté en retirant le noyau du matériau calciné et à chauffer le matériau calciné dans une atmosphère réductrice,
dans lequel le noyau utilisé dans l'étape de calcination est composé d'un matériau présentant un coefficient de dilatation thermique linéaire supérieur à celui de l'alliage Cu-Ga constituant la cible de pulvérisation en alliage Cu-Ga,
le matériau calciné est formé en maintenant la poudre de matière première à une température de 100 °C ou plus, et de 600 °C ou moins, pendant 10 minutes ou plus, et 10 heures ou moins, dans l'étape de calcination et
l'étape de frittage principal est réalisée dans une condition de température de (Tm - 150) °C ou plus et inférieure à Tm °C dans l'étape de frittage principal, où Tm correspond à une température, à laquelle une phase liquide de l'alliage Cu-Ga apparaît sous une pression de 101 à 106 kPa (1,00 à 1,05 atm) en degrés Celsius.

2. Procédé de fabrication d'une cible de pulvérisation en alliage Cu-Ga selon la revendication 1,
dans lequel la poudre de matière première inclut une poudre de Cu et la poudre d'alliage Cu-Ga, et une teneur de la poudre de Cu est 5 % en masse ou plus.

3. Procédé de fabrication d'une cible de pulvérisation en alliage Cu-Ga selon la revendication 1,
dans lequel la poudre de matière première inclut une première poudre d'alliage Cu-Ga présentant une concentration en Ga dans une plage de plus de 0 % atomique et de 20 % atomique ou moins et une seconde poudre d'alliage Cu-Ga présentant une concentration en Ga dans une plage de plus de 20 % atomique et de 70 % atomique ou moins et une teneur de la première poudre d'alliage Cu-Ga est 5 % en masse ou plus.

4. Procédé de fabrication d'une cible de pulvérisation en alliage Cu-Ga selon l'une quelconque des revendications 1 à 3,
dans lequel une teneur de Ga dans la poudre de matière première est de 20 % atomique ou plus et de 40 % atomique ou moins.
